Europäisches Patentamt

European Patent Office

Office européen des brevets

(19)

(11) **EP 1 403 663 A1**

(12) **EUROPEAN PATENT APPLICATION**
published in accordance with Art. 158(3) EPC

(43) Date of publication:
**31.03.2004 Bulletin 2004/14**

(21) Application number: **01938695.2**

(22) Date of filing: **15.06.2001**

(51) Int Cl.7: **G02B 1/02**, H01L 21/027, G03F 7/20

(86) International application number:
**PCT/JP2001/005132**

(87) International publication number:
**WO 2002/103413 (27.12.2002 Gazette 2002/52)**

(84) Designated Contracting States:
**AT BE CH CY DE DK ES FI FR GB GR IE IT LI LU MC NL PT SE TR**
Designated Extension States:
**AL LT LV MK RO SI**

(71) Applicant: **Nikon Corporation**
**Tokyo 100-8331 (JP)**

(72) Inventors:
- **SAKUMA, Shigeru, c/o NIKON CORPORATION Chiyoda-ku, Tokyo 100-8331 (JP)**
- **SHINADA, Kuninori, c/o NIKON CORPORATION Chiyoda-ku, Tokyo 100-8331 (JP)**

(74) Representative: **HOFFMANN - EITLE**
**Patent- und Rechtsanwälte**
**Arabellastrasse 4**
**81925 München (DE)**

(54) **OPTICAL MEMBER, PROCESS FOR PRODUCING THE SAME, AND PROJECTION ALIGNER**

(57)     The optical member of the present invention is an optical member comprising a fluoride crystal; and having an optical axis forming an angle of 10° to 36° with a <111> axis of the fluoride crystal, and a birefringence of 2.0 nm/cm or less in the optical axis direction.

The optical member of the present invention can improve the yield and processing accuracy in the process of making the optical member, and can achieve sufficiently high optical characteristics.

EP 1 403 663 A1

## Description

### Technical Field

The present invention relates to an optical member and a method of making the same, and a projection exposure apparatus; and, more specifically, to an optical member using a fluoride crystal belonging to a cubic crystal such as calcium fluoride crystal and a method of making the same, and a projection optical apparatus using this optical member.

### Background Art

In recent years, along with higher integration and higher function in integrated circuits such as VLSI (Very Large Scale Integration), techniques for carrying out finer processing on a wafer when transferring integrated circuit patterns thereto have been in demand, whereby methods for improving imaging performances such as resolution and focal depth have been under consideration in projection exposure apparatus (photolithography apparatus) employed for transferring integrated circuit patterns.

At a fixed exposure wavel ength $\lambda$ in thephotolithography using a projection exposure apparatus, the angle of diffracted light increases as the pattern is finer, whereby' the diffracted light cannot be taken in unless a lens has a large NA. As the exposure wavelength $\lambda$ is shorter, on the other hand, the angle of diffracted light becomes smaller in the same pattern, whereby the NA of lens may be kept small. Namely, it has been presumed that, since the resolution and focal length are given by the following expressions (2) and (3) :

$$(\text{resolution}) = k_1 \cdot \lambda / \text{NA} \tag{2}$$

$$(\text{focal depth}) = k_2 \cdot \lambda / (\text{NA})^2 \tag{3}$$

where $k_1$ and $k_2$ indicate proportional constants, it will be sufficient if the lens increases its NA (the lens increases its diameter) in order to improve the resolution or shorten the exposure wavelength $\lambda$, and shortening $\lambda$ is advantageous in terms of focal depth.

Therefore, in order to improve imaging performances in projection exposure apparatus, the shortening of exposure light sources for use has been in progress. Specifically, light sources have been shifting from g-line (wavelength at 436 nm) to i-line (wavelength at 365 nm), KrF excimer laser (wavelength at 248 nm), and ArF excimer laser (wavelength at 193 nm) , whereas the use of $F_2$ laser (wavelength at 157 nm), x-rays, electron beams, and the like has also been under study.

Meanwhile, in projection exposure apparatus utilizing light having such a short wavelength, optical materials used in lenses and the like of illumination optical systems and projection optical systems are usually restricted from the viewpoints of transmittance to light and the like. When light having a wavelength of 250 nm or shorter is utilized, for example, calcium fluoride crystal or silica glass is employed as an optical material in general. When $F_2$ laser light is utilized, on the other hand, silica glass fails to yield a sufficient transmittance, whereby only calcium fluoride crystal is considered practically usable.

Examples of fluoride crystal used in optical members include calcium fluoride ($CaF_2$; fluorite), barium fluoride ($BaF_2$), strontium fluoride ($SrF_2$), and the like, which belong to a cubic system.

Optical members made of these fluoride crystals can be obtained by cutting out an optical material from a fluoride crystal ingot obtained by a crystal growing method such as Bridgman method (Stockbarger method or crucible pulling down method), and then subjecting this optical material to machining, annealing, polishing, and the like.

In the crystal growing method, no preferential orientations seem to exist in terms of crystal growth, so that orientations are often arbitrary in a surface (horizontal plane) perpendicular to the center axis of thus obtained ingot. On the other hand, the birefringence in thus obtained ingot usually becomes smaller in the direction of <111> axis.

Therefore, whenusing a fluoride crystal ingot obtained by the crystal growingmethod, it is important that the optical material be cut out in view of the relationship between the orientation of crystal growth and the optical axis. For example, Japanese Patent Application Laid-Open No. HEI 11-326189 discloses a method of making an optical device in which the observation direction that minimizes birefringence (optical axis direction) is caused to coincide with the <111> axis of fluoride crystal or a direction orthogonal to the {111} plane of fluoride crystal, and states that optical performance is improved when thus obtained optical device is used.

Also, SPIE, vol. 3424, p. 10-19 (1998) states that, since the hardness of calcium fluoride crystal depends on crystal orientation, it is important that, for enhancing the processing accuracy of optical members, they must be cut perpendicular to the <111> axis of calcium fluoride crystal, so that the cuttingplane andthe {111} plane coincide with each other.

Disclosure of the Invention

However, orientations in the fluoride crystal obtained by the crystal growing method are arbitrary as mentioned above, whereby it is necessary that, for making the optical axis of an optical member coincide with the <111> axis or a direction perpendicular to the {111} plane, an optical material be cut out such that its cutting plane forms a predetermined angle with a horizontal plane of the ingot.' Here, the yield at the time of cutting out a plurality of optical materials from a single ingot may deteriorate depending on the orientation of <111> axis of fluoride crystal in the ingot, thereby necessitating a very large number of ingots. Also, depending on the orientation of <111> axis of fluoride crystal, it becomes difficult for the <111> axis of fluoride crystal and the optical axis to coincide with each other when cutting out an optical material having a large diameter, whereby optical members having a desirable optical characteristic may not be obtained.

When cutting out an optical material such that the horizontal plane of the ingot and the cutting plane become parallel to each other in order to improve the yield, the cutting plane of the optical material and the {111} plane of fluoride crystal do not usually coincide with each other, whereby a sufficient processing accuracy (surface accuracy) is often unattainable in the polishing due to the difference in hardness caused by orientations.

In view of problems of the prior art mentioned above, it is an object of the present invention to provide an optical member and a method of making the same, which can improve the yield and processing accuracy in the process of making an optical member and achieve sufficiently high optical characteristics, and a projection exposure apparatus using this optical member.

The inventors conducted diligent studies in order to achieve the above-mentioned object and, as a result, have found that the above-mentioned problems are solved in an optical member comprising a fluoride crystal when the angle formed between the <111> axis of fluoride crystal and the optical axis and the birefringence in the optical axis direction satisfy respective specific conditions, thereby accomplishing the present invention.

Namely, the optical member in accordance with the present invention is an optical member comprising a fluoride crystal;

the optical member having an optical axis forming an angle of 10° to 36° with a <111> axis of the fluoride crystal, and a birefringence of 2.0 nm/cm or less in the optical axis direction.

The method of making an optical member in accordance with the present invention includes:

a first step of producing a fluoride crystal ingot by a crystal growing method;
a second step of cutting out an optical material from the fluoride crystal ingot such that a <111> axis of the fluoride crystal and an optical axis form an angle of 10° to 36° therebetween;
a third step of decreasing a birefringence in the optical axis direction of the optical material to 2.0 nm/cm or less by a crystal heat treatment method; and
a fourth step of producing the optical member by polishing the fluoride crystal material obtained by the third step.

Further, the projection exposure apparatus in accordance with the present invention is a projection exposure apparatus comprising a reticle having a pattern, an illumination optical system for irradiating the reticle with light having a wavelength of 250 nm or shorter, and a projection optical system for forming onto a wafer an image of a pattern formed upon irradiation of the reticle with light;

wherein at least one kind selected from the group consisting of the illumination optical system and the projection optical system comprises the above-mentioned optical member in accordance with the present invention.

In the present invention, since the angle formedbetween the <111> axis of fluoride crystal and the optical axis is 10° to 36° whereas the birefringence in the optical axis direction is 2.0 nm/cm or less, the degree of freedom in cutting out an optical material from the fluoride crystal can be increased without deteriorating optical characteristics of the resulting optical member, whereby the yield and processing accuracy in the process of making the optical member can be improved. Thus obtained optical member of the present invention can achieve sufficiently high optical characteristics, whereby the projection exposure apparatus of the present invention comprising the above-mentioned optical member of the present invention can attain sufficiently high imaging performance.

Preferably, in the optical member of the present invention, the birefringence within a predetermined plane orthogonal to the optical axis is 5.0 nm/cm or less. When the birefringence within a predetermined plane orthogonal to the optical axis is 5.0 nm/cm or less, optical characteristics of the optical member tend to become higher.

Preferably, the optical member in accordance with the present invention has a curved surface whose center of rotation is the optical axis, the curved surface having a radius of curvature and a diameter satisfying the condition represented by the following expression (1):

$$D/R \geq 5 \qquad\qquad (1)$$

where D indicates the diameter [mm], and R indicates the radius of curvature [mm], and the <111> axis of fluoride crystal and the optical axis form an angle of 10° to 24° therebetween. When the radius of curvature and diameter of the curved surface satisfy the condition represented by the above-mentioned expression (1) whereas the angle formed between the <111> axis of fluoride and the optical axis is 10° to 24°, the yield in the manufacturing process and the processing accuracy in the polishing tend to improve more.

**Brief Description of the Drawings**

Fig. 1 is an explanatory view showing a preferred embodiment of the optical member in accordance with the present invention;
Fig. 2 is a schematic diagram showing a preferred embodiment of the projection exposure apparatus in accordance with the present invention;
Fig. 3 is a schematic diagram showing an example of projection optical system used in the projection exposure apparatus of the present invention;
Fig. 4 is a schematic diagram showing another example of projection optical system used in the projection exposure apparatus of the present invention;
Fig. 5 is a schematic diagram showing another example of projection optical system used in the projection exposure apparatus of the present invention; and
Fig. 6 is a schematic diagram showing another example of projection optical system used in the projection exposure apparatus of the present invention.

**Best Modes for Carrying Out the Invention**

In the following, preferred embodiments of the present invention will be explained in detail with reference to the drawings when appropriate. In the drawings, parts identical or equivalent to each other will be referred to with numerals identical to each other.

The optical member in accordance with the present invention is an optical member comprising a fluoride crystal;
the optical member having an optical axis forming an angle of 10° to 36° with a <111> axis of the fluoride crystal; and a birefringence of 2.0 nm/cm or less in the optical axis direction.

In the present invention, when a crystal plane in a cubic system is expressed as {111} plane by using Miller indices, all the axes perpendicular to this {111} plane are referred to as <111> axis, which encompasses not only [111] axis but also such axes as [1-11], [-1-11], and [-111] crystallographically equivalent thereto. The {111} plane refers to the (111) plane, which is a crystal face in the cubic system, and all the planes crystallographically equivalent thereto, thus encompassing planes such as (1-11), (-1-11), and (-111).

The optical axis birefringence in the present invention refers to the maximum optical axis birefringence [nm/cm] among those measured at given 100 to 300 points within a circle having a diameter which is 0.95 times that of the optical member or optical material about the center of rotation of the optical member or optical material.

Examples of fluoride crystal used in the present invention include calcium fluoride ($CaF_2$; fluorite) , barium fluoride ($BaF_2$), strontium fluoride ($SrF_2$), and the like, which belong to a cubic system. Among them, calcium fluoride is preferably used, since it yields an optical member having higher optical characteristics, and a projection exposure apparatus using this optical member tends to achieve higher imaging performance.

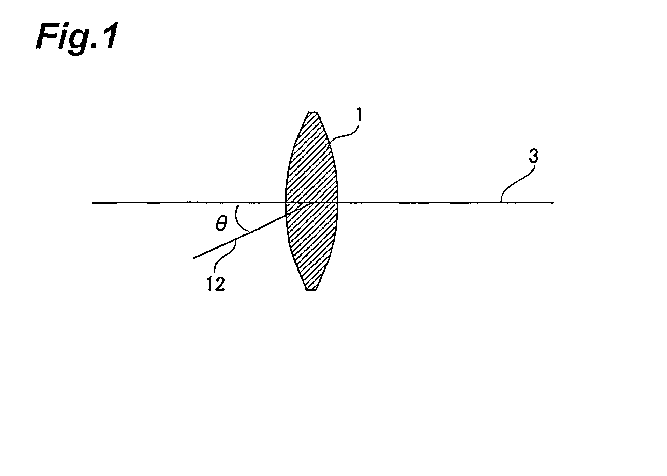

In the optical member of the present invention, as shown in Fig. 1, the angle θ formed between the <111> axis of fluoride crystal and the optical axis 3 of the optical member 1 is required to be 10° to 36°, and is preferably 16° to 24°. The yield at the time of making the optical member will deteriorate if θ is less than 10°, whereas the processing accuracy (surface accuracy) in polishing will be insufficient if θ exceeds 36°.

Also, in the optical member of the present invention, the birefringence in the direction of optical axis 3 of the optical member (hereinafter referred to as optical axis birefringence) is required to be 2.0 nm/cm or less, and is preferably 1.0 nm/cm or less. If the optical axis birefringence exceeds 2.0 nm/cm, optical characteristics become insufficient, whereby a proj ection exposure apparatus using such an optical member fails to achieve sufficient imaging performances.

In the optical member of the present invention, the birefringence within a predetermined plane (e.g., surface 4) at a right angle with optical axis 3 (hereinafter referred to as off-axis birefringence) is preferably 5.0 nm/cm or less, more preferably 3.0 nm/cm or less. When the off-axis birefringence exceeds 5.0 nm/cm, optical characteristics may become so low that a projection exposure apparatus using such an optical member tends to fail to achieve sufficient imaging performances.

The off-axis birefringence in the present invention refers to the maximum off-axis birefringence [nm/cm] among those measured at 3 or more points located inside the outer peripheral surface of the optical member or optical material by at least 3 mm from the end part toward the axis of rotation thereof at each of 12 angles at intervals of 30° about the circumference.

When used as a lens for an illumination optical system or projection optical system, the optical member of the present invention is usually provided with a curved surface whose center of rotation is the optical axis. In the case with such a curved surface, it is preferred that the radius of curvature and diameter of the curved surface satisfy the condition represented by the following expression (1):

$$D/R \geq 5 \qquad\qquad (1)$$

where D indicates the diameter [mm], and R indicates the radius of curvature [mm], and the <111> axis of fluoride crystal and the optical axis form an angle of 10° to 24° therebetween. When the radius of curvature and diameter of the curved surface satisfy the condition represented by the above-mentioned expression (1) while the angle formedbetween the <111> axis of fluoride crystal and the optical axis is 10° to 24°, the yield in the manufacturing process and the processing accuracy in polishing tend to improve more. When the curved surface of the optical member is subjected to polishing, accurate polishing the curved surface usually tends to become more difficult as the D/R increases, whereby it has been difficult for conventional optical members to attain a sufficient processing accuracy when the D/R exceeds 5. By contrast, the present invention tends to attain a higher processing accuracy in the polishing step by forming an angle of 10° to 24° between the <111> axis of fluoride crystal and the optical axis.

Though Fig. 1 shows the optical member 1 having two convex surfaces as a preferred embodiment of the optical member in accordance with the present invention, the curved surface in the optical member of the present invention may have any form of convex and concave surfaces. R in the above-mentioned expression (1) can be treated as a positive value whether the curved surface is a convex or concave surface. When the optical member has two curved surfaces having respective radii of curvature different from each other, the smaller of the two R values can represent them.

The making method in accordance with the present invention will now be explained.

In the making method in accordance with the present invention, a fluoride crystal ingot is obtained by a crystal growing method such as Bridgman method (Stockbarger method or crucible pulling down method) at first. For example, when growing a calcium fluoride crystal, a crucible is filled with a mixture of a calcium fluoride material and a scavenger (fluorinating agent) such as lead fluoride ($PbF_2$), and is placed within a crystal growing apparatus. After the apparatus is evacuated (normally to a pressure of $10^{-3}$ to $10^{-4}$ Pa), the material is heated to the melting point of calcium fluoride or higher, so as to be molten, and the crucible is pulled down at a predetermined rate (usually at 0.1 to 5 mm/hr) , so that the molten material gradually crystallizes from the lower part of the crucible. While the crystal growth ends at the time when the uppermost part of the molten liquid is crystallized, annealing is usually carried out to a temperature near room temperature in order to prevent thus grown crystal ingot from cracking. As such, a fluoride crystal ingot is obtained.

As the calcium fluoride material, synthesized one having excluded impurities as much as possible therefrom is used preferably. Though natural fluorite can also be used as the calcium fluoride material, optical characteristics of the resulting optical member tend to lower when fluorite contains a large amount of impurities.

Examples of the form of calcium fluoride material include powders, semi-molten products, pulverized products, and the like, whereas crystal-grown blocks may be reused as well. Among these materials, powder materials may remarkably decrease their volumes upon melting. Using a semi-molten product, apulverizedproduct, or a crystal-grown block can evade such a phenomenon.

Subsequently, from the ingot obtained by the process mentioned above, a fluoride crystal material is cut out such that the <111> axis of fluoride crystal and the optical axis form an angle of 10° to 36° therebetween. When the fluoride crystal is cut out such that the <111> axis of fluoride crystal and the optical axis satisfy the above-mentioned condition, the yield can be improved without deteriorating optical characteristics, and an optical member having a large aperture can be obtained.

When obtaining an optical material by cutting along two planes parallel to each other and perpendicular to the optical axis, the angle formed between the <111> axis of fluoride crystal and the optical axis equals the angle formed between the {111} surface and the cutting planes. Therefore, in such a case, an optical material in which the <111> axis and the optical axis form an angle of 10° to 36° therebetween can be obtained when cut such that the {111} surface and the cutting planes form an angle of 10° to 36°.

When providing the optical member with a curved surface satisfying the condition represented by the above-mentioned expression (1) in a polishing step which will be explained later, it is preferred that the optical material be cut out from the ingot such that the <111> axis of fluoride crystal and the optical axis form an angle of 10° to 24° therebetween as mentioned above.

Further, the optical material cut out from the ingot is subjected to heat treatment by a crystal heat treatment method, whereby the birefringence in the optical axis birefringence becomes 2.0 nm/cm or less. In the case of small-size optical members, window materials requiring no homogeneity, and the like, optical materials cut out from the ingot may be used after rounding and the like without being heat-treated. When employed for lenses and the like of illumination optical systems and projection optical systems of projection exposure apparatus, however, the optical axis birefringence and off-axis birefringence are large, and so forth, so that homogeneity becomes insufficient, whereby a sufficient processing accuracy is not obtained in the polishing step that will be explained later, and the projection exposure fails to attain sufficient imaging performance.

The heat treatment (annealing) by the crystal heat treatment method is not restricted in particular as long as it can suppress the birefringence in the optical axis direction to 2.0 nm/cm or less. For example, an optical material and a small amount of ammonium bifluoride ($NH_4HF_2$) are put into a tightly sealed container made of stainless steel, they are heated to a temperature of 1020° to 1150°C while adjusting the gas pressure so as to attain a fluorine atmosphere within the container after evacuation, this state is held for 24 to 48 hours, and then they are cooled at a cooling rate of 0.5 to 2.0°C/hr, whereby the birefringence in the optical axis direction can fall within the range mentioned above.

Further, thus heat-treated optical material is subjected to polishing, whereby the optical member of the present invention is obtained.

While specific examples of polishing in accordance with the present invention include pitch polishing using pitch, which is a viscoelastic material, a crystal polishing method using a polisher in which at least one of graphite powder and carbon whisker is compounded with an epoxy resin, and the like, polishing is preferably carried out by the crystal polishing method. Polishing an optical material by the crystal polishing method is effective in improving the transfer characteristic, machining characteristic, and mechanical strength, shifting the thermal deformation temperature to the higher temperature side, and reducing the frictional heat at the time of polishing, so that, even when the hardness varies depending on crystal orientations, the amount of removal becomes substantially uniform, whereby surging components remaining in the processed surface tend to be reduced sufficiently.

When polishing is carried out by the pitch polishing method, relatively large surges may remain in the processed surface in the optical member under the influence of the viscoelasticity of pitch. However, the surging component remaining in the processed surface can sufficiently be reduced when polishing is effected by the crystal polishing' method after carrying out rough polishing by the pitch polishing method, whereby a sufficiently high processing accuracy can be obtained.

Thus, the making method of the present invention can sufficiently enhance the yield and processing accuracy in the polishing when yielding the optical member of the present invention having sufficiently high optical characteristics. Using thus obtained optical member of the present invention in lenses and the like constituting illumination optical systems andproj ection optical systems of projection exposure apparatus can obtain sufficiently high imaging performance. In particular, the optical member and projection exposure apparatus of the present invention are quite useful when a light source in the ultraviolet or vacuum ultraviolet region at a wavelength of 250 nm or shorter such as KrF excimer laser (wavelength at 248 nm), ArF excimer laser (wavelength at 193 nm), or $F_2$ laser (wavelength at 157 nm), or a solid-state laser in this wavelength region is utilized as an exposure light source.

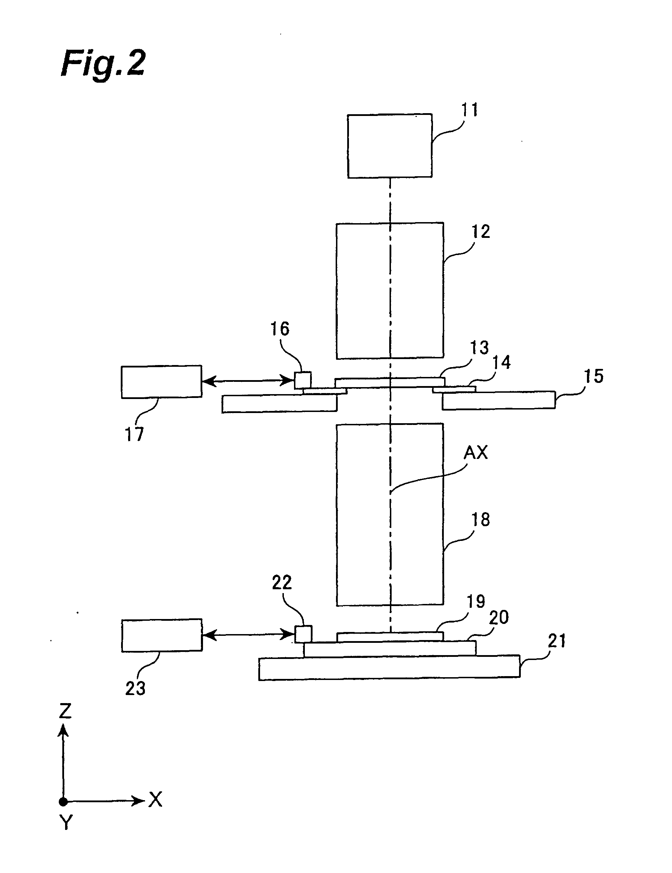

Fig. 2 is a schematic diagram showing a preferred embodiment of the projection exposure apparatus in accordance with the present invention. In Fig. 2, Z axis is set parallel to the optical axis AX of a catadioptric system 18 constituting a projection optical system, whereas X and Y axes are set parallel and perpendicular to the paper surface within a plane perpendicular to the optical axis AX, respectively.

The projection exposure apparatus shown in Fig. 2 comprises an $F_2$ laser (wavelength at 157 nm) as a light source 11 for supplying illumination light in an ultraviolet region. By way of an illumination optical system 12, the light emitted from the light source 11 uniformly illuminates a mask 13 formed with a predetermined pattern.

In the optical path from the light source 11 to the illumination optical system 12, one or a plurality of bending mirrors for changing the optical path are disposed as required. The illumination optical system 12 is constituted by a flyeye lens, an internal reflection type integrator, and the like, for example, while having optical systems such as a field stop for defining a surface light source having a predetermined size and form, and a field stop imaging optical system for projecting an image of the field stop onto the mask 13. Further, the optical path between the light source 11 and the illumination optical system 12 is tightly sealed with a casing (not depicted) , whereas the space between the light source 11 and the optical member disposed on the side closer to the mask 13 in the illumination optical system 12 is substituted by an inert gas (nitrogen, helium, or the like) exhibiting a low absorptivity with respect to the exposure light.

By way of a mask holder 14, the mask 13 is held parallel to the XY plane on a mask stage 15. The mask 13 is formed with a pattern to transfer, whereas a slit-like pattern region having a longer side along the Y axis direction and a shorter side along the X axis direction in the whole pattern area is illuminated.

The mask stage 15 is constructed so as to be two-dimensionally movable along the mask surface (XY plane), whereas its positional coordinates are determined and controlled by an interferometer 17 using a mask movable mirror 16.

Thus, the mask 13, mask holder 14, and mask stage 15 disposed between the illumination optical system 12 and projection optical system 18 are accommodated in a casing (not depicted), the inside of which is substituted by an inert gas (nitrogen, helium, or the like).

By way of the catadioptric projection optical system 18, the light from the pattern formed on the mask 13 forms a mask pattern image on a wafer 19 which is a photosensitive substrate. By way of a wafer holder 20, the wafer 19 is held parallel to the XY plane on the wafer stage 21. On the wafer 19, the pattern image is formed in a slit-like exposure area having a longer side along the Y axis direction and a shorter side along the X axis direction so as to optically correspond to the slit-like illumination region on the mask 13.

The wafer stage 21 is constructed so as to be two-dimensionallymovable along the wafer surface (XY plane), whereas its positional coordinates are determined and controlled by an interferometer 23 using a wafer movable mirror 22.

The wafer 19, wafer holder 20, and wafer stage 21 are accommodated in a casing (not depicted) , the inside of which is substituted by an inert gas (nitrogen, helium, or the like).

Thus, in the projection exposure apparatus shown in Fig. 2, an atmosphere suppressing the absorption of exposure light is formed throughout the optical path extending from the light source 11 to the wafer 19.

Also, as mentioned above, each of the illumination area (field area) on the mask 13 and the projection area (exposure area) on the wafer 19, which are formed by the projection optical system 18, has a slit-like form with a short side extending in the X axis direction. Therefore, while controlling the positions of mask 13 and wafer 19 by using a driving system, the interferometers 17, 23, and the like, the mask stage 15 and wafer stage 21, and optionally the mask 13 and wafer 19 as well, are moved in synchronization along the shorter side direction (X axis direction) of the slit-like illumination and exposure areas, whereby a region having a width identical to the longer side of the exposure area and a length corresponding to the scanning amount (moving amount) of the wafer 19 on the wafer 19 is exposed to light in a scanning fashion.

At least one of optical members (lenses and the like) constituting the illumination optical system 12 and projection optical systems 18 is the optical member in accordance with the present invention, whereby the proj ection exposure apparatus having such a configuration in accordance with the present invention can achieve sufficiently high imaging performance (resolution, focal depth, and the like).

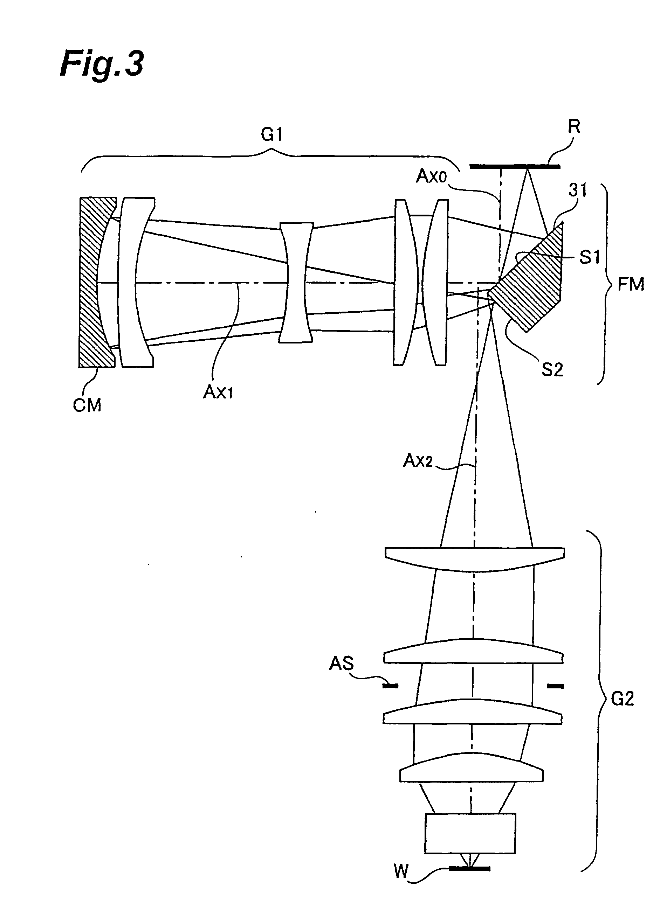

Fig. 3 is a schematic diagram showing an example of projection optical system used in the projection exposure apparatus of the present invention.

In Fig. 3, the projection optical system has a first imaging optical system G1 of catadioptric type for forming an intermediate image of a pattern disposed on a reticle R acting as a projection original, and a second imaging optical system G2 of refraction type for re-forming an intermediate image caused by the first imaging optical system G1 onto a wafer W acting as a work. Disposed on an optical axis AX1 is an optical path bending member comprising an optical path bending mirror 31 having a reflecting surface S1 for deflecting the optical path from the reticle R to the first imaging optical system G1 by 90°and a reflecting surface S2 for deflecting the optical path from the first imaging optical system G1 to the second imaging optical system by 90°.

The first imaging optical system G1 has a plurality of lens components and a concave mirror which are arranged along the optical axis AX1, and forms the intermediate image at a magnification of 1 : 1 or under a slight demagnification. The second imaging optical system G2 has a plurality of lens components arranged along an optical axis AX2 orthogonal to the optical axis AX1, and a variable aperture stop AS for regulating the coherence factor, and forms a secondary image with a predetermined demagnification according to light from the intermediate image.

Here, an optical axis AX0 in Fig. 3 is an optical axis, orthogonal to the optical axisAX1 of the first imaging optical system G1, between the reticle R and the mirror 31, whereas the optical axes AX0 and AX2 are parallel to each other. Here, the optical axes AX0 and AX2 may be located on the same line as well.

Though Fig. 3 shows a projection optical system comprising the first imaging optical system G1 and second imaging optical system G2 each having a plurality of lens components, either a single lens component or a plurality of lens components may be arranged along the optical axis AX1, AX2.

Further, the angle formed between the optical axes AX0 and AX1 is not required to be 90° but may be an angle by which the concave mirror CM is rotated counterclockwise, for example. Here, the optical axis bending angle at the reflecting surface S2 is preferably set such that the reticle R and the wafer W are parallel to each other.

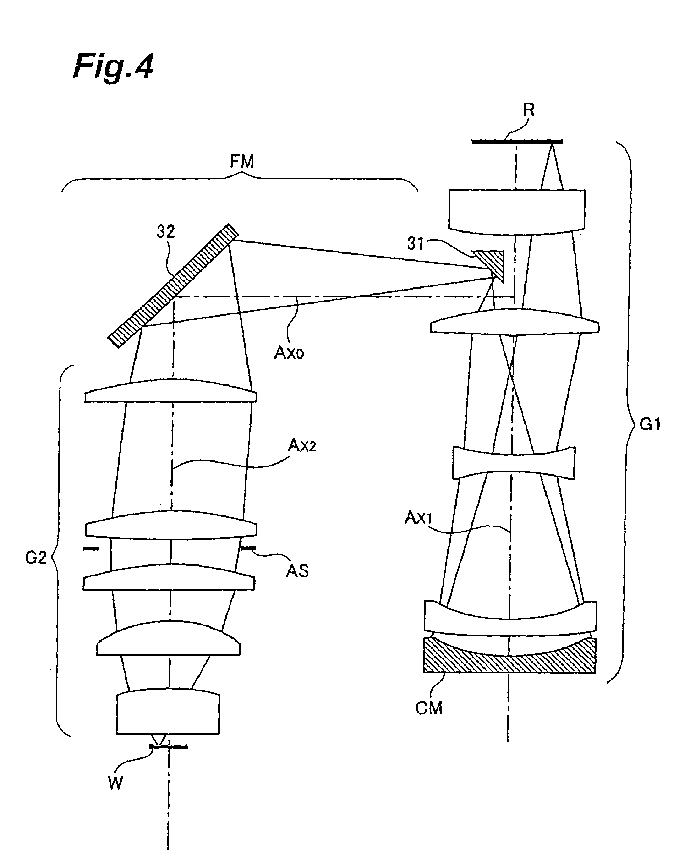

As shown in Fig. 4, a projection optical system comprising two mirrors 31, 32 can also be used in the present' invention.

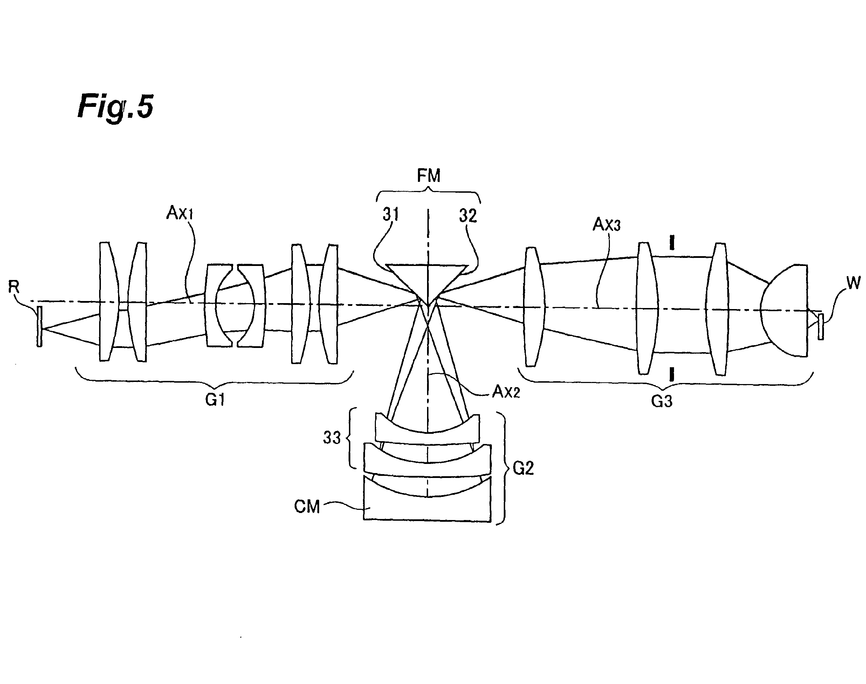

Further, in the present invention, aprojectionoptical system having the configuration shown in Fig. 5 can be used as well. In Fig. 5, the projection optical system comprises a first imaging optical system G1 of catadioptric type for forming an intermediate pattern on a reticle R acting as a projection original. A first optical path bending mirror 31 is disposed near the first intermediate image formed by the first imaging optical system G1, whereby the luminous flux directed to the first intermediate image or the luminous flux from the first intermediate image is deflected toward a second imaging optical system by the first optical path bending mirror 31. The second imaging optical system G2 has a concave mirror CM and at least one negative lens 33, and forms a second intermediate image (an image of the first intermediate image while being a secondary image of the pattern) near the first intermediate image at substantially the same magnification as that of the first intermediate image according to the luminous flux from the first intermediate image.

Disposed near the position where the second intermediate image is formed by the second imaging optical system G2 is a second optical path bending mirror 32, whereby the luminous flux directed to the second intermediate image or the luminous flux from the second intermediate image is deflected toward a third imaging optical system G3 by the second optical path bending mirror 32. Here, the reflecting surface of the first optical path bending mirror 31 and the reflecting surface of the second optical path bending mirror 32 are arranged such that they do not overlap each other spatially.

According to the luminous flux from the second intermediate image, the third imaging optical system G3 forms a reduced image (an image of the second intermediate image while being the final image of the catadioptric optical system) of the pattern of the reticle R onto a wafer W acting as a work (photosensitive substrate) arranged on the second surface.

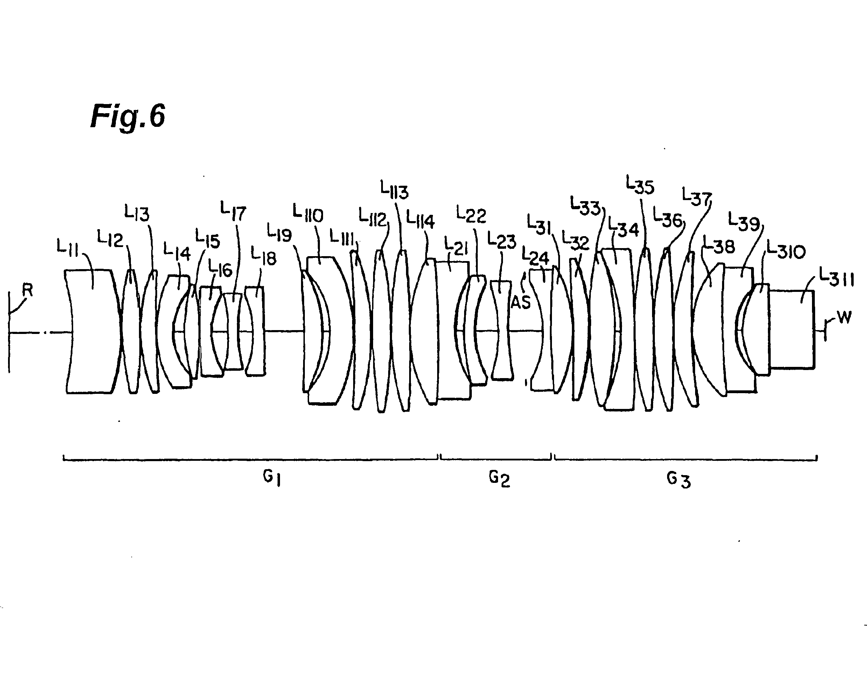

The above-mentioned projection optical systems shown in Figs. 3 to 5 are favorably used when the exposure light source is an $F_2$ laser, for example. When the exposure light source is an ArF excimer laser, for example, a projection optical system having the lens configuration shown in Fig. 6 is used favorably on the other hand.

In Fig. 6, a first lens group $G_1$ having a positive power, a second lens group $G_2$ having a positive power, a third lens group $G_3$ having a negative power are formed successively from the side of a reticle R acting as a first object, while both the object side (reticle R side) and image side (wafer W side) are substantially telecentric, and a demagnification is provided. This projection optical system exhibits anN.A. of 0.6, a projection magnification of 1/4, and an image-side exposure area with a diameter of 30.6.

Usually, when the projection optical system has the lens configuration shown in Fig. 6, materials of individual lenses are selected in order to correct the chromatic aberration as appropriate. For example, silica glass is employed as a material for 14 lenses $L_{11}$ to $L_{114}$ constituting the first lens group $G_1$, silica glass is employed as a material for 4 lenses $L_{21}$ to $L_{24}$ constituting the second lens group $G_2$, a fluoride crystal is employed as a material for 6 out of 11 lenses $L_{31}$ to $L_{311}$ constituting the third lens group $G_3$, and silica glass is employed as the remaining 5 lenses thereof, whereby chromatic aberration can be corrected favorably.

While at least one of optical members (lens components and the like) constituting the illumination optical system and projection optical system in the projection exposure apparatus of the present invention is required to be the optical member of the present invention as mentioned above, preferably each of all the optical members constituting the projection optical system is the optical member of the present invention, more preferably each of all the optical members constituting the illumination optical system and projection optical system is the optical member of the present invention.

Example

In the following, the present invention will further be explained with reference to Examples and Comparative' Examples, though the present invention is not restricted by the following Examples at all.

Example 1

(Making of Calcium Fluoride Crystal)

A minute amount (1.5 [mol%]) of lead fluoride as a fluorinating agent was added to a powder material of calcium fluoride synthesized while minimizing impurities. Immediately thereafter, they were fully mixed by using a stirrer, and the resulting mixture was heated to melt in a vacuum at $10^{-3}$ to $10^{-4}$ Pa, so as to prepare a polycrystal. The surface of the polycrystal was scrubbed with a calcium fluoride crystal piece, so as to remove impurities, and then the polycrystal was further washed with ethanol. A crucible having a diameter of 300 mm made of carbon was filled with 60 kg of the polycrystal. After the system was set to a pressure of $10^{-3}$, to $10^{-4}$ Pa, temperature was raised to the melting point or higher over 2 days so as to eliminate oxygen and moisture from the surface, and then this state was held for 8 hours. Thereafter, while the temperature near the heater was set to 1450°C so as to melt the polycrystal within the crucible, the crucible was pulled down at a descending rate of 1.0 nm/hr by a pulling down length of 400 mm, whereby a calcium fluoride crystal ingot having a total length of 350 mm was obtained.

(Cutting Out Optical Material)

The {111} plane and <111> axis were determined in thus' obtained calcium fluoride crystal ingot, and an optical material having a diameter of 260 mm and a thickness of 60 mm was cut out therefrom such that the angle formed between the cutting plane and {111} plane, i.e., the angle formed between the <111> axis and optical axis, became 10°.

(Annealing)

Thus obtained optical material was put into a sealable container together with 150 g of ammoniumbifluoride (NH$_4$HF$_2$). After being evacuated, the container was heated to 1050°C in a fluorine atmosphere and held for 48 hours, and then was cooled at a cooling rate of 0.5°C/hour.
The optical axis birefringence and off-axis birefringence were measured in the optical material after annealing, whereby the optical axis birefringence was 1.2 nm/cm whereas the off-axis birefringence was 3.8 nm/cm.

(Polishing)

Apolisher was prepared by curing a mixture constituted by 5 parts by weight of epoxy resin polythiol (Bond-Quick 5 manufactured by Konishi), 5 parts by weight of a curing agent, and 0.05 part by weight of graphite.
Subsequently, using the above-mentioned polisher, the annealed optical member was polished by a crystal polishing method, so as to prepare an optical member having a curved surface with a diameter (D) of 250 mm and a radius of curvature (R) of 358 mm (D/R = 0.70).
The surface accuracy of thus obtained optical member was 0.0100λ (λ = 632.8 nm, ditto in the following) in terms of RMS value (root mean square).
All the lenses required for the projection optical system (projection optical system having the configuration shown in Fig. 6) in the projection exposure apparatus using an ArF excimer laser as a light source or the projection optical system (projection optical system having the configuration shown in Fig. 5) in the projection exposure apparatus using an F$_2$ laser as a light source were prepared by the procedure mentioned above. Table 1 shows the respective weights of the ingots used for preparing the lenses in the individual projection optical systems.

Examples 2 and 3 and Comparative Examples 1 to 6

In Examples 2 and 3 and Comparative Examples 1 to 6, optical members were prepared in the same manner as Example 1 except that the angle formed between the <111> axis and optical axis at the time of cutting out the optical material from the ingot, the optical axis birefringence and off-axis birefringence in the optical material after annealing, and the radius of curvature of the curved surface (i.e., D/R) in the polishing were set as shown in Table 1. The surface accuracy in the polishing in each of Examples and Comparative Examples is shown in Table 1.
In Examples 2 and 3 and Comparative Example 1, all the lenses constituting the projection optical system for ArF excimer laser or F$_2$ laser were prepared as in Example 1. Table 1 shows the respective weights of the ingots used for preparing the lenses in individual Examples and Comparative Examples.

TABLE 1

| | EXAMPLE 1 | EXAMPLE 2 | EXAMPLE 3 | COMPARATIVE EXAMPLE 1 | COMPARATIVE EXAMPLE 2 | COMPARATIVE EXAMPLE 3 | COMPARATIVE EXAMPLE 4 | COMPARATIVE EXAMPLE 5 | COMPARATIVE EXAMPLE 6 |
|---|---|---|---|---|---|---|---|---|---|
| ANGLE BETWEEN <111> AXIS AND OPTICAL AXIS [°] | 10 | 20 | 30 | 0 | 0 | 40 | 10 | 20 | 30 |
| OPTICAL AXIS BIREFRINGENCE [nm/cm] | 1.2 | 1.4 | 1.5 | 1.3 | 3.1 | 2.0 | 2.7 | 2.5 | 2.9 |
| OFF-AXIS BIREFRINGENCE [nm/cm] | 3.8 | 3.2 | 5.7 | 3.9 | 4.8 | 2.9 | 4.0 | 3.6 | 5.6 |
| RADIUS OF CURVATURE [mm] | 358 | 733 | 350 | 358 | 483 | 400 | 305 | 451 | 451 |
| D/R | 0.70 | 0.34 | 0.71 | 0.70 | 0.58 | 0.63 | 0.82 | 0.55 | 0.55 |
| SURFACE ACCURACY | $0.0100\lambda$ | $0.0170\lambda$ | $0.0270\lambda$ | $0.0110\lambda$ | $0.0210\lambda$ | $0.0520\lambda$ | $0.550\lambda$ | $0.0450\lambda$ | $0.0590\lambda$ |
| INGOT WEIGHT REQUIRED FOR PROJECTION OPTICAL SYSTEM [kg] — FOR ARF EXCIMER LASER | 165 | 140 | 120 | 225 | 225 | – | – | – | – |
| INGOT WEIGHT REQUIRED FOR PROJECTION OPTICAL SYSTEM [kg] — FOR $F_2$ LASER | 445 | 370 | 320 | 595 | 595 | – | – | – | – |

EP 1 403 663 A1

In Examples 1 to 3, as shown in Table 1, the surface accuracy at the time of polishing was sufficiently high, and the yield was favorable when preparing any of the lenses in the ArF excimer laser projection optical system or $F_2$ laser projection optical system.

Industrial Applicability

As explained in the foregoing, the optical member and method of making the same in accordance with the present invention can improve the yield and processing accuracy in the process of making the optical member, and can attain sufficiently high optical characteristics. Further, the projection exposure apparatus of the present invention comprising the optical member of the present invention can achieve sufficiently high imaging performance, and is quite usable in photolithography utilizing light having a wavelength of 250 nm or shorter in particular.

**Claims**

1.   An optical member comprising a fluoride crystal;
     said optical member having an optical axis forming an angle of 10° to 36° with a <111> axis of said fluoride crystal, and a birefringence of 2.0 nm/cm or less in said optical axis direction.

2.   An optical member according to claim 1, wherein a predetermined plane orthogonal to said optical axis has a birefringence of 5.0 nm/cm or less therewithin.

3.   An optical member according to claim 1, wherein said optical member comprises a curved surface whose center of rotation is said optical axis, said curved surface having a radius of curvature and a diameter satisfying a condition represented by the following expression (1):

$$D/R \geq 5 \tag{1}$$

     where D indicates the diameter [mm], and R indicates the radius of curvature [mm], and the <111> axis of said fluoride crystal and said optical axis form an angle of 10° to 24° therebetween.

4.   A method of making an optical member including:

     a first step of producing a fluoride crystal ingot by a crystal growing method;
     a second step of cutting out an optical material from' said fluoride crystal ingot such that a <111> axis of said fluoride crystal and an optical axis form an angle of 10° to 36° therebetween;
     a third step of decreasing a birefringence in the optical axis direction of said optical material to 2.0 nm/cm or less by a crystal heat treatment method; and
     a fourth step of producing said optical member by polishing said fluoride crystal material obtained by said third step.

5.   A projection exposure apparatus comprising:

     a reticle having a pattern, an illumination optical system for irradiating said reticle with light having a wavelength of 250 nm or shorter, and a projection optical system for forming onto a wafer an image of a pattern formed upon irradiation of said reticle with light;

     wherein at least one kind selected from the group consisting of said illumination optical system and said projection optical system comprises the optical member according to claim 1.

*Fig.1*

# Fig.2

# Fig.3

# Fig.4

Fig.5

EP 1 403 663 A1

Fig.6

## INTERNATIONAL SEARCH REPORT

| International application No. |
|---|
| PCT/JP01/05132 |

| A. CLASSIFICATION OF SUBJECT MATTER |
|---|
| Int.Cl⁷  G02B1/02, H01L21/027, G03F7/20 |

According to International Patent Classification (IPC) or to both national classification and IPC

**B. FIELDS SEARCHED**

Minimum documentation searched (classification system followed by classification symbols)
Int.Cl⁷  G02B1/02, H01L21/027, G03F7/20

Documentation searched other than minimum documentation to the extent that such documents are included in the fields searched
Jitsuyo Shinan Koho        1926-1996    Toroku Jitsuyo Shinan Koho  1994-2001
Kokai Jitsuyo Shinan Koho  1971-2001    Jitsuyo Shinan Toroku Koho  1996-2001

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | EP 942297 A2 (Nikon Corporation), 15 September, 1999 (15.09.99), Full text; all drawings & JP 11-326189 A Full text; all drawings & US 6201634 A | 1-5 |
| Y | JP 11-21197 A (Canon Inc.), 26 January, 1999 (26.01.99), Full text; all drawings (Family: none) | 1-5 |
| Y | JP 8-5801 A (Nikon Corporation), 12 January, 1996 (12.01.96), Full text; all drawings (Family: none) | 1-5 |
| Y | JP 11-60382 A (Nikon Corporation), 02 March, 1999 (02.03.99), Full text; all drawings (Family: none) | 1-5 |

☒ Further documents are listed in the continuation of Box C.    ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier document but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 September, 2001 (06.09.01) | 18 September, 2001 (18.09.01) |

| Name and mailing address of the ISA/ Japanese Patent Office | Authorized officer |
|---|---|
| Facsimile No. | Telephone No. |

Form PCT/ISA/210 (second sheet) (July 1992)

**INTERNATIONAL SEARCH REPORT**

| International application No. |
| --- |
| PCT/JP01/05132 |

**C (Continuation).  DOCUMENTS CONSIDERED TO BE RELEVANT**

| Category* | Citation of document, with indication, where appropriate, of the relevant passages | Relevant to claim No. |
| --- | --- | --- |
| Y | JP 2000-128696 A (Nikon Corporation), 09 May, 2000 (09.05.00), Full text; all drawings & US 6201634 B1 | 1-5 |

Form PCT/ISA/210 (continuation of second sheet) (July 1992)